Europäisches Patentamt

European Patent Office

Office européen des brevets

(11) Publication number: **0 188 709**
A1

# EUROPEAN PATENT APPLICATION

(21) Application number: **85115264.5**

(22) Date of filing: **02.12.85**

(51) Int. Cl.⁴: **H 03 K 19/017**

(30) Priority: **04.12.84 IT 6819984**

(43) Date of publication of application: **30.07.86**
**Bulletin 86/31**

(84) Designated Contracting States: **DE FR GB NL SE**

(71) Applicant: **CSELT Centro Studi e Laboratori Telecomunicazioni S.p.A., Via Guglielmo Reiss Romoli, 274, I-10148 Turin (IT)**

(72) Inventor: **Gandini, Marco, Via Lessona, 35 bis, Torino (IT)**
Inventor: **Ghislo, Guido, C.so Vercelli, 19, Ivrea Torino (IT)**

(74) Representative: **Riederer Freiherr von Paar zu Schönau, Anton et al, Freyung 615 Postfach 2664, D-8300 Landshut (DE)**

(54) **Bus-precharge circuit for MOS integrated components.**

(57) The circuit provides, as a load for a bus of a MOS integrated circuit, an enhancement MOS transistor TLI in parallel with a depletion MOS transistor (TL2).

**PATENTANWÄLTE**

0188709

Dipl.-Ing. Anton Freiherr
**Riederer von Paar**

D-8300 Landshut
Postfach 2664, Freyung 615
☎ Landshut (0871) 22170
Fax (CCITT 2) manuell
Telex 58441 glala d

- 1 -

Frhr. Riederer v. Paar, Postfach 2664, D-8300 Landshut

CSELT

Centro Studi e Laboratori

Telecomunicazioni S.p.A.

Turin, Italy

Partner in München:
**Dr. H. O. DIEHL**
☎ München (089) 177061
Fax (089) 177461 (autom.)
Telex 5215145 Zeus d

## Bus-Precharge Circuit For MOS Integrated Components

### 1 Description

The present invention relates to a load circuit implemented with MOS transistors and particularly suited for the precharge of a bus of a MOS integrated circuit.

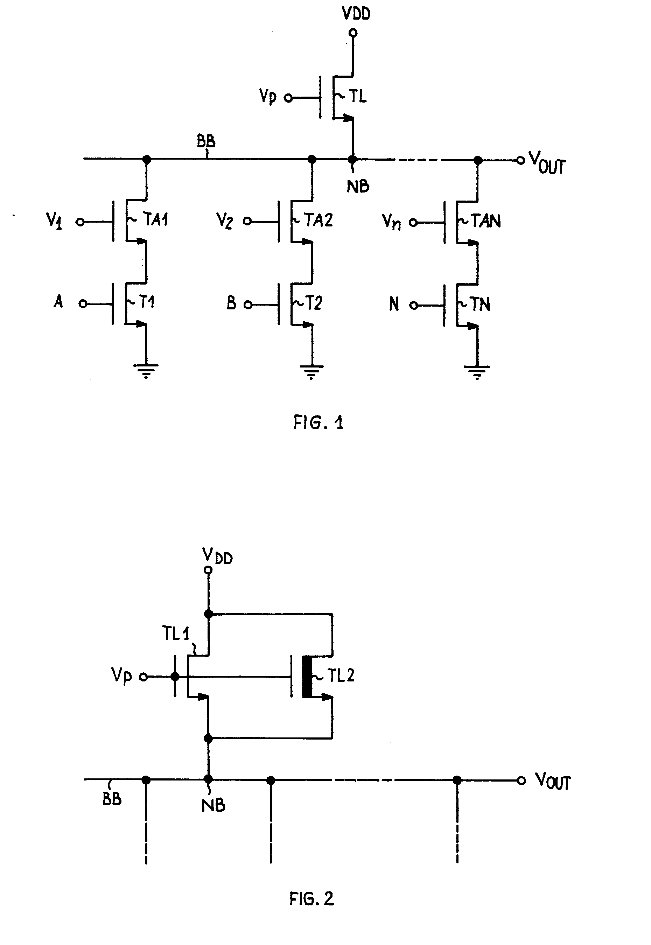

By bus of an integrated circuit in MOS technology we intend a known configuration of the prevailing logic level kind, as depicted in Fig. 1.

The bus physical line is denoted by BB and supplies a logic output level $V_{OUT}$; MOS transistor TL is used as a load and receives supply voltage $V_{DD}$ at the drain.

The source of TL is connected to bus BB, while the gate receives logic signal $V_P$ hereinafter referred to as "precharge signal" of node NB which presets transistor TL to conduction; i.e. it presets the voltage on the bus to the non prevailing logic level.

In the non limiting example here described non-prevailing logic level is "1". TA1,TA2... TAN denote N transistors in MOS technology enabling logic signal transfers on bus BB. Said transistors have drains connected to bus BB and receive on corresponding gates enabling signals $V_1, V_2, \ldots V_N$ which preset corresponding transistors to conduction.

T1,T2,...TN denote other N transistors in MOS technology for the transfer of logic signals A,B,...N, applied to corresponding gates, on the corresponding drains in turn connected to sources of corresponding enabling transistors TA1,... TAN. The sources of transistors T1,T2,...TN are grounded.

During the time intervals in which precharge signal $V_p$, which presets to conduction transistor TL, is active, the circuit of Fig. 1 executes the following logic function:

$$V_{OUT} = \overline{(V_1*A) + (V_2*B) + ..... + (V_N*N)}$$

where symbol * indicates the logic AND and symbol + the logic OR.

The complemented value is determined by the intrinsically inverting structure of the circuit of Fig. 1, since between gate and drain of each transistor an inversion of phase and hence of logic level occurs.

If one of signals A,...N passes to prevailing logic level, the corresponding branch of circuit in Fig. 1 conducts, as well as transistor TL; voltage $V_{OUT}$ on bus BB passes also to prevailing logic level.

In the non-limiting example of Fig. 1, all the tranistors are n-channel MOS transistors.

In known circuits TL is an enhancement MOS transistor, because such a type of transistor has a higher switching speed and hence dissipates less than a depletion MOS transistor not convenient to be used in this case.

However an enhancement MOS transistor introduces a gate/source voltage drop equal to its threshold voltage $V_{GST}$; $V_{GST}$ depends on the process used to manufacture transistors, and has a minimum value equal to about 0.8-1.2 V.

This threshold voltage $V_{GST}$ reduces the voltage swing on bus BB, since $V_{OUT} = V_{DD} - V_{GST}$ ; hence it decreases noise-immunity of high logic level on bus BB, which noise-immunity would be maximum if $V_{OUT} = V_{DD}$, otherwise possibile if TL were a depletion MOS transistor.

Then increased speed and low dissipation are counterbalanced by worse noise immunity. Then in accordance with the present invention the circuit of Fig. 1 is modified as shown in Fig. 2: transistor TL is replaced by the parallel of two MOS transistors: TL1 of the enhancement type and TL2 of the depletion type.

TL1 and TL2 drains are connected to voltage supply $V_{DD}$ sources to bus BB, and gates to precharge voltage $V_p$.

So, the advantage is obtained of noise-immunity due to the presence of the depletion MOS transistor, which keeps $V_{OUT} = V_{DD}$.

The advantages of higher speed and less dissipation are also obtained since most of the drain current is made to flow in the enhancement MOS transistor. More particularly, drain current in both transistor types depends on the ratio $K = W/L$, where W and L are channel width and lenght respectively.

Hence the physical sizes of depletion MOS transistor TL2 are kept small, while those of enhancement MOS transistor TL1 are rendered proportional to desired drain current so that most of said current may flow through enhancement transistor TL1.

Modifications and variations to the just described embodiment are possible without going out of the scope of the invention.

# Claims

1. Circuit for the precharge of a bus of a MOS integrated circuit, comprising a load circuit and driving circuits both made of MOS transistors (T1,TA1; T2,TA2;...TN,TAN) to transfer on said bus logic signals (A,B,...N), characterized in that said load circuit comprises an enhancement MOS transistor (TL1) and a depletion MOS transistor (TL2) connected in parallel.

2. Circuit as in claim 1, characterized in that the physical dimensions of said depletion MOS transistor (TL2) are kept small, and those of said enhancement MOS transistor (TL1) proportional to a current value which flows in said load circuit, so that said current may mostly flow into said enhancement transistor.

FIG. 1

FIG. 2

0188709

# EUROPEAN SEARCH REPORT

Application number

EP 85 11 5264

European Patent Office

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 055 570 (FUJITSU) <br> * Figure 12; page 31, line 17 - page 33, line 17 * | 1,2 | H 03 K 19/017 |
| X | PATENTS ABSTRACTS OF JAPAN, vol. 2, no. 134, 9th November 19 78, page 8327 E 78; & JP - A - 53 102 660 (HITACHI SEISAKUSHO K.K.) 07-09-1978 <br> * Figure; page 8327 E 78 * | 1 | |
| A | Idem | 2 | |
| X | PATENTS ABSTRACTS OF JAPAN, vol. 1, no. 58, 6th June 1977, page 36 E 77; & JP - A - 52 2156 (HITACHI SEISAKUSHO K.K.) 08-01-1977 <br> * Figure; page 36 E 77 * | 1 | |
| A | | 2 | |

TECHNICAL FIELDS
SEARCHED (Int. Cl.4)

H 03 K

The present search report has been drawn up for all claims

| Place of search | Date of completion of the search | Examiner |
|---|---|---|
| THE HAGUE | 25-03-1986 | FEUER F.S. |